# EUROPÄISCHE PATENTSCHRIFT

(11) **EP 1 618 664 B1**
(45) Veröffentlichungstag und Bekanntmachung des Hinweises auf die Patenterteilung: **24.01.2007**
(21) Anmeldenummer: 04724276.3
(22) Anmeldetag: 30.03.2004
(51) Int. Cl.: H03K 17/26, H03K 17/16, H04B 3/54, G08C 19/02

(54) **STEUEREINGANGSSCHALTUNG FÜR EIN ELEKTRISCHES GERÄT**
CONTROL INPUT CIRCUIT FOR AN ELECTRICAL DEVICE
CIRCUIT D'ENTREE DE COMMANDE POUR UN APPAREIL ELECTRIQUE

(30) Priorität: 25.04.2003 EP 03009468
(43) Veröffentlichungstag der Anmeldung: 25.01.2006
(73) Patentinhaber: SIEMENS AKTIENGESELLSCHAFT, 80333 München (DE)
(72) Erfinder: APFELBACHER, Walter, 92271 Freihung (DE); REICHENBACH, Norbert, 92224 Amberg (DE); SEITZ, Johann, 92224 Amberg (DE)
(86) Internationale Anmeldenummer: PCT/EP2004/003357
(87) Internationale Veröffentlichungsnummer: WO 2004/098059

(56) Entgegenhaltungen:
- EP-A- 0 294 139
- DE-A- 3 934 007
- US-A- 4 949 359
- US-A- 5 179 488
- US-A- 6 140 940

## Beschreibung

Die Erfindung bezieht sich auf eine Steuereingangsschaltung für ein elektrisches Gerät, mit einem Auswertemodul, das dazu ausgebildet ist, ein in einer Steuerleitung übermitteltes elektronisches Steuersignal zu detektieren.

Eine solche Steuereingangsschaltung ist beispielsweise aus US 4,949,359 A bekannt.

Ein Steuereingang ist eine elektrische Schnittstelle eines Geräts, über welche elektronische Steuersignale von einem externen Steuergerät an das mit dem Steuereingang versehene Gerät gegeben werden können. Solche Steuersignale umfassen beispielsweise Ein- und Ausschaltbefehle. Bei dem mit dem Steuereingang versehenen Gerät handelt es sich um ein beliebiges elektrisches Gerät, das elektronische Steuersignale erfassen und verarbeiten kann, insbesondere ein elektrisches Motorgerät, ein Messgerät, ein Daten-Aufnahme- oder Wiedergabegerät oder dergleichen. Bei einem Steuergerät kann es sich insbesondere um eine speicherprogrammierbare Steuerung (SPS) handeln.

Das Steuersignal erfolgt durch Anlegen einer Steuerspannung an den Steuereingang des Geräts. Der dem Steuereingang zugeordneten Steuereingangsschaltung kommt hierbei die Aufgabe zu, den durch die Steuerspannung angeregten Steuerstrom aufzunehmen und bei Vorliegen eines Steuersignals eine dem Steuersignal entsprechende Reaktion des Geräts auszulösen.

Es sind verschiedene Steuerspannungen üblich, die sich bezüglich Spannungshöhe und Spannungsform, insbesondere Gleich- oder Wechselspannung, unterscheiden. Insbesondere ist die Verwendung von 24V DC, 48V DC, 110V AC, 230V AC usw. als Steuerspannung gebräuchlich. Gemäß herkömmlicher Nomenklatur steht DC hierbei für Gleichspannung und AC für Wechselspannung.

Um die Kompatibilität eines Gerätes zu erhöhen, und gleichzeitig eine möglichst geringe Anzahl verschiedener Steuereingänge bereitstellen zu müssen, ist es üblich, einen Steuereingang für eine Bandbreite von mehreren Steuerspannungen auszulegen, z.B. für 24V DC bis 48V DC oder 110V AC bis 230V AC. Wünschenswert wäre in diesem Zusammenhang ein Steuereingang, der für alle gängigen Spannungshöhen sowie für Gleich- und Wechselspannungen gleichermaßen geeignet ist.

Dies kann von einer herkömmlichen Steuereingangsschaltung mit rein ohmscher Eingangscharakteristik im Allgemeinen nicht oder nur unzureichend erfüllt werden, zumal mit steigender Steuerspannung üblicherweise auch ein steigender Reststrom zu berücksichtigen ist, der unvermeidlicher Weise auch dann durch die das Gerät mit dem Steuergerät verbindende Steuerleitung fließt, wenn gerade kein Steuersignal anliegt. Dieser Reststrom wird zudem überlagert von Störströmen, die insbesondere durch kapazitive Störeinkopplung auf die Steuerleitung übertragen werden. Eine solche Störeinkopplung kann beispielsweise auftreten, wenn die Steuerleitung in der Nähe eines nur unzureichend abgeschirmten Netzkabels verlegt ist. Eine für breitbandige Steuerspannungen ausgelegte Steuereingangsschaltung muss zwangsweise eine vergleichsweise niedrige Auslöseschwelle aufweisen, um bei Verwendung einer niedrigen Steuerspannung sicher auszulösen. Dadurch besteht bei einer Steuereingangsschaltung mit ohmscher Charakteristik jedoch andererseits verstärkt die Gefahr, dass bei Verwendung einer hohen Steuerspannung die Auslöseschwelle schon aufgrund des Reststroms und/oder des Störstroms überschritten wird.

Zur Erhöhung der Breitbandigkeit eines Steuereingangs wird bisweilen auch eine Steuereingangsschaltung verwendet, die eine Konstantstromsenke enthält. Unter dem Begriff Konstantstromsenke wird ein Schaltungsmodul verstanden, das innerhalb eines vorgegebenen Spannungsintervalls eine von der anliegenden Spannung weitgehend unabhängige Stromaufnahme aufweist. Bei einer Steuereingangsschaltung der letztgenannten Art kann üblicherweise jedoch nur eine vergleichsweise geringe Stromaufnahme eingestellt werden, um die maximal in der Steuereingangsschaltung auftretende Verlustleistung und die damit verbundene Aufheizung des Geräts auf ein vertretbares Maß zu begrenzen. Die maximale Stromaufnahme, die einstellbar ist, ohne dass ein aufwändiger Überhitzungsschutz vorgesehen werden muss, ist dabei oft zu gering, um den nach den einschlägigen Normen, z.B. EN 61131-2:1994 geforderten minimalen Einschaltstrom zu erreichen.

Der Erfindung liegt die Aufgabe zugrunde, eine Steuereingangsschaltung für ein elektrisches Gerät anzugeben, die hinsichtlich Spannungshöhe und Spannungsform für eine besonders große Bandbreite von Steuerspannungen geeignet ist. Insbesondere soll die Steuereingangsschaltung hierbei unempfindlich gegenüber einem kapazitiven Störstrom sein und einen geringen elektrischen Verlust aufweisen. Der Erfindung liegt weiterhin die Aufgabe zugrunde, ein im Hinblick auf einen Steuereingang verbessertes elektrisches Gerät anzugeben.

Bezüglich der Steuereingangsschaltung wird die Aufgabe erfindungsgemäß gelöst durch die Merkmale des Anspruchs 1. Die Steuereingangsschaltung umfasst danach eine bezüglich ihrer Stromaufnahme gepulst betriebene Konstantstromsenke. Die Stromaufnahme nimmt hierbei während der Dauer eines Detektionspulses einen Detektionswert an. Zwischen je zwei zeitlich aufeinander folgenden Detektionspulsen ist die Stromaufnahme im Vergleich zu diesem Detektionswert erniedrigt. Zur Erkennung eines anliegenden Steuersignals umfasst die Steuereingangsschaltung weiterhin ein Auswertemodul. Dieses ist derart ausgelegt, dass ein Steuersignal angezeigt wird, d.h. insbesondere von einer internen Gerätesteuerung des Geräts erkennbar ist, wenn während des Detektionspulses der Steuerstrom für eine vorgegebene Einschaltdauer einen vorgegebenen Einschaltwert nicht unterschreitet.

Bezüglich des Geräts wird die Aufgabe erfindungsgemäß gelöst durch die Merkmale des Anspruchs 19. Dem Steuereingang des Geräts ist danach die erfindungsgemäße Steuereingangsschaltung zugeordnet.

Durch den gepulsten Betrieb der Konstantstromsenke wird die im Steuereingang anfallende mittlere Verlustleistung auf ein vergleichsweise geringes Maß reduziert, zumal die Konstantstromsenke nur während der Detektionspulse einen erhöhten Stromfluss, und damit eine nennenswerte Verlustleistung, zulässt. In einer Ruhephase zwischen je zwei aufeinander fogenden Detektionspulsen ist dagegen die Stromaufnahme auf ein geringes Maß reduziert, so dass während der Ruhephase nur eine geringe Verlustleistung auftritt. Die während des vorangegangenen Detektionspulses angefallene Verlustwärme wird daher während der Ruhephase schon mit einfachen Mitteln hinreichend abgeleitet, um eine Überhitzung des Geräts zu vermeiden. Dies erlaubt wiederum, die Stromaufnahme während eines Detektionspulses besonders groß zu wählen, wodurch die Störanfälligkeit der Steuereingangsschaltung im Hinblick auf Störströme herabgesetzt ist. Mit einem Auswertemodul, das das Vorliegen eines Steuersignals nur dann anzeigt, wenn während der vorgegebenen Einschaltzeit der Steuerstrom einen vorgegebenen Einschaltwert nicht unterschreitet, können Störeinflüsse ausgeblendet werden. Der Einschaltwert ist vorteilhafterweise geringfügig kleiner gewählt als der Detektionswert der Stromaufnahme, aber groß gegenüber der Stromaufnahme der Konstantstromsenke während der Ruhephase. Die Einschaltdauer liegt in der Größenordnung des Detektionspulses, ist aber bevorzugt etwas kürzer als letztere gewählt, um Flankenanstiegszeiten der Eingangsspannung und dergleichen abzufangen.

Zur Ansteuerung der Konstantstromsenke, d.h. zur Vorgabe des Betrags der Stromaufnahme, ist diese bevorzugt mit einem Ansteuermodul beschaltet. Dieses ist vorteilhaft durch eine Oszillatorschaltung realisiert, deren Gesamtwiderstand diskret zwischen zwei Werten wechselt. Eine solche diskrete Oszillatorschaltung wird auch als astabile Kippschaltung oder Multivibrator bezeichnet (siehe U. Tietze, Ch. Schenk, Halbleiterschaltungstechnik, 11. Aufl., Kap. 6.2.3, S. 603, 1999, Berlin (Springer Verlag)). In einer kompakten und hinsichtlich des Bauteileaufwands günstigen Alternative ist als Ansteuermodul ein Mikroprozessor vorgesehen. Dieser Mikroprozessor nimmt zweckmäßigerweise zusätzlich zur Ansteuerung der Konstantstromsenke auch weitere Steuerfunktionen für das Gerät wahr.

In bevorzugter Ausführung ist der Konstantstromsenke eine Diode vorgeschaltet. Dies ertüchtigt die Steuereingangsschaltung in besonders einfacher Weise zur Aufnahme sowohl von Gleichspannung als auch von Wechselspannung. Im Hinblick auf die Verwendung einer Wechselspannung als Steuerspannung tritt der zusätzliche Vorteil auf, dass infolge der gleichrichtenden Wirkung der Diode die Steuereingangsschaltung nur für eine Spannungspolarität ausgelegt sein muss. Weiterhin findet nur während der in Durchlassrichtung der Diode gepolten Halbwelle der Steuerspannung ein Stromfluss durch die Konstantstromsenke statt, was zu einer weiteren Reduzierung der im Steuereingang anfallenden Verlustleistung beiträgt.

Das Auswertemodul ist auf besonders einfache Weise durch ein RC-Glied gebildet, welches bei einem anliegenden Steuersignal beladen wird. Das RC-Glied ist dabei derart dimensioniert, dass die über dem RC-Glied anliegende Ausgabespannung einen Auslösewert erreicht, sobald während der vorgegebenen Einschaltdauer der Steuerstrom den vorgegebenen Einschaltwert nicht unterschreitet. Um Störeinflüsse sicher auszublenden, ist dem RC-Glied vorteilhafterweise eine Schwellenschaltung vorgeschaltet, die nur dann leitend wird, wenn der in der Steuerleitung fließende Eingangsstrom betragsmäßig einen Einschaltwert übersteigt.

In einer einfachen und wirksamen Ausführung ist die Konstantstromsenke durch einen Feldeffekttransistor (FET) gebildet, dessen Gate-Anschluss an eine konstante Spannung gelegt ist.

Bevorzugt folgen die Detektionspulse zeitlich periodisch aufeinander. Bei Verwendung einer Gleichspannung als Steuerspannung wird dabei die Periodendauer vom Ansteuermodul fest vorgegeben. Bei Verwendung einer Wechselspannung als Steuerspannung koordiniert (oder synchronisiert) das Ansteuermodul hingegen zweckmäßigerweise die Periode der Detektionspulse mit der Phase der Steuerspannung. Die Detektionspulse werden hierbei also durch die Steuerspannung "getriggert", so dass der Verlauf der Steuerspannung während der Dauer eines beliebigen Detektionspulses stets gleich ist. Das Ansteuermodul ist insbesondere derart ausgebildet, dass der Beginn eines Detektionspulses stets mit dem Beginn einer positiven Halbwelle der Steuerspannung zusammenfällt. Hierdurch fällt insbesondere bei einer sinusförmigen Steuerspannung eine besonders geringe Verlustleistung an.

In im Hinblick auf gängige Steuerspannungen, d.h. insbesondere 24V - 230V AC/DC, besonders vorteilhafter Dimensionierung der Steuereingangsschaltung ist die Stromaufnahme der Konstantstromsenke zwischen zwei aufeinander folgenden Detektionspulsen gegenüber dem Detektionswert um mindestens einen Faktor 10, insbesondere mindestens einen Faktor 20, erniedrigt, wohingegen der Einschaltwert des Auswertemoduls auf ca. 85% des Detektionswertes festgelegt ist. Der Detektionswert beträgt hierbei insbesondere etwa 8mA. Die vorgegebene Einschaltdauer, während der der Eingangsstrom zur Auslösung eines Steuervorgangs den Einschaltwert überschreiten muss, beträgt mindestens 70%, bevorzugt etwa 90% der Dauer eines Detektionspulses. Weiterhin übersteigt die Zeitspanne zwischen zwei aufeinander folgenden Detektionspulsen, d.h. die Dauer der Ruhephase, die Dauer eines Detektionspulses um mindestens das zweifache. Insbesondere beträgt die Dauer der Ruhephase etwa das Vierfache der Dauer eines Detektionspulses. Die Dauer eines Detektionspulses beträgt dabei insbesondere etwa 4ms.

Die im voranstehenden Absatz aufgeführten Zahlenwerte und Relationen können auch einzeln sowie in beliebiger Kombination als vorteilhafte Ausbildungen der Erfindung zum Einsatz kommen.

Um einen kompakten Aufbau der Steuereingangsschaltung und einen geringen Bauteileaufwand zu erzielen, sind die Steuereingangsschaltung oder Teile davon bevorzugt als integrierter Schaltkreis (ASIC) realisiert.

Die erfindungsgemäße Steuereingangsschaltung ist insbesondere vorteilhaft in einem durch elektronische Steuersignale ansteuerbaren elektrischen Gerät einsetzbar. Der Einsatz der Steuereingangsschaltung in dem Gerät gewährleistet eine besonders hohe Kompatibilität mit verschiedenen Steuergeräten. Das mit der erfindungsgemäßen Steuereingangsschaltung ausgestattete Gerät kann insbesondere mit allen gängigen Steuerspannungen, z.B. 24V - 230V AC/DC angesprochen werden, ohne dass eine spezielle Anpassung des Steuereingangs erforderlich ist. Hierbei fällt auch bei einer hohen Steuerspannung im Zeitmittel nur eine vergleichsweise geringe Verlustleistung im Steuereingang an, so dass keine aufwendigen Vorkehrungen zur Abfuhr der Verlustwärme erforderlich sind. Dies ermöglicht eine günstige und kompakte Realisierung des Geräts.

Nachfolgend werden Ausführungsbeispiele der Erfindung anhand einer Zeichnung näher erläutert. Darin zeigen:
- FIG 1: schematisch eine Schaltanordnung mit einem elektrischen Gerät und einem, das Gerät über eine Steuerleitung ansprechenden Steuergerät,
- FIG 2: in einem schematischen Diagramm den zeitlichen Verlauf der Steuerspannung und des in der Steuerleitung fließenden Eingangsstroms während eines Steuersignals bei Verwendung einer sinusförmigen Steuerspannung,
- FIG 3: in einer Darstellung gemäß FIG 2 die Steuerspannung und den Eingangsstrom während eines Steuersignals bei zeitlich konstanter Steuerspannung,
- FIG 4: in einem elektronischen Schaltbild eine Steuereingangsschaltung des Geräts, und
- FIG 5: in einem elektronischen Schaltbild eine alternative Ausführung der Steuereingangsschaltung.

Einander entsprechende Teile und Größen sind in den Figuren stets mit dem gleichen Bezugszeichen versehen.

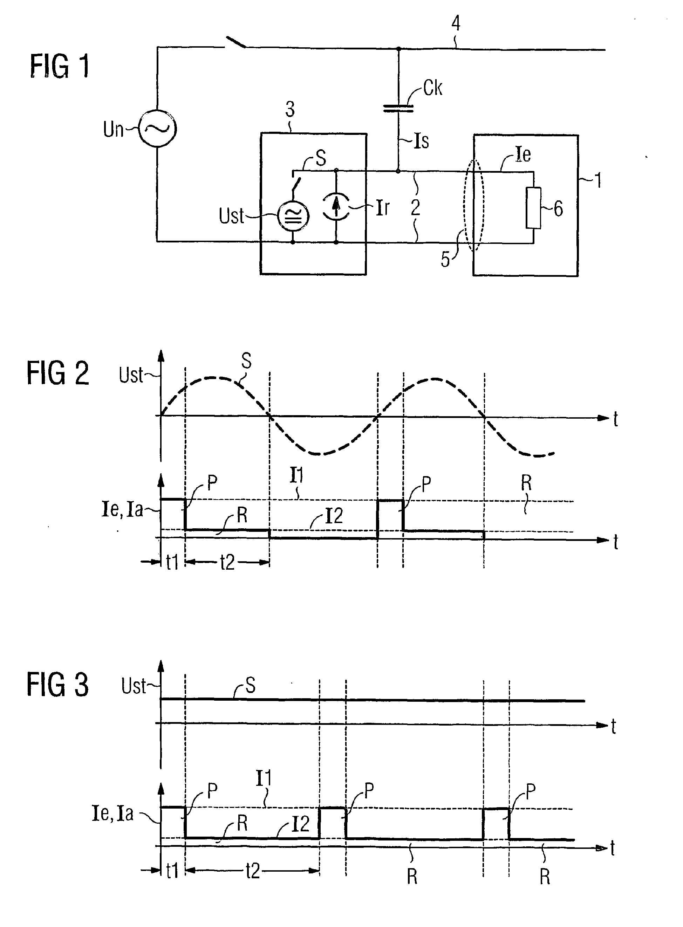

FIG 1 zeigt in grober schematischer Vereinfachung eine Schaltanordnung mit einem elektrischen Gerät 1, welchem über eine Steuerleitung 2 von einem externen Steuergerät 3 elektronische Steuersignale S zugeführt werden. Das Gerät 1 ist beispielsweise ein elektronisches Motorgerät. Bei dem Steuergerät 3 handelt es sich beispielsweise um eine speicherprogrammierbare Steuerung, insbesondere einen Computer.

Das Steuergerät 3 ist seinerseits über eine Netzspannung Un führende Netzleitung 4 spannungsversorgt.

Zur Erzeugung eines Steuersignals S legt das Steuergerät 3 eine Steuerspannung Ust an einen Steuereingang 5 des Geräts 1 an. Der Steuereingang 5 bildet bezüglich der Steuerleitung 2 die Schnittstelle des Geräts 1 mit dem Geräteäußeren. Als Steuerspannung Ust wird wahlweise eine Gleichspannung oder eine Wechselspannung herangezogen. Der Spannungsbetrag bzw. die Spannungsamplitude der Steuerspannung Ust ist hierbei je nach Ausbildung des Steuergeräts 3 üblicherweise zwischen 24V und 230V gewählt. Die Steuerspannung Ust liegt an einer innerhalb des Gerätes 1 in die Steuerleitung 2 geschalteten Steuereingangsschaltung 6 an. Die Steuereingangsschaltung 6 analysiert die in der Steuerleitung 2 anliegende Spannung und steuert bei Vorliegen eines Steuersignals S eine nicht näher dargestellte interne Gerätesteuerung entsprechend an. Das Steuersignal S ist beispielsweise ein An- oder Ausschaltbefehl. Das Gerät 1 wird in diesem Fall bei anliegender Steuerspannung Ust an- bzw. ausgeschaltet.

Bei Vorliegen eines Steuersignals S wird die Steuereingangsschaltung 6 unter Wirkung der anliegenden Steuerspannung Ust von einem vergleichsweise starken Eingangsstrom Ie durchflossen. Bei nicht aktivierter Steuerleitung 2, d.h. in Abwesenheit eines Steuersignals S, ist der Betrag des Eingangsstroms Ie demgegenüber auf ein geringes Maß reduziert. Der Eingangsstrom Ie nimmt jedoch auch bei Abwesenheit eines Steuersignals S im Allgemeinen einen von Null deutlich verschiedenen Betrag an. Dies liegt zum einen an einem innerhalb des Steuergeräts 3 unvermeidlicherweise auftretenden Reststrom Ir, dem zum anderen ein Störstrom Is überlagert ist. Der Störstrom Is wird vorwiegend kapazitiv in die Steuerleitung 2 eingekoppelt. Dies geschieht z.B. durch benachbarte Verlegung der Steuerleitung 2 mit der Netzleitung 4, sofern letztere nicht hinreichend gut abgeschirmt ist. Die Koppelkapazität Ck zwischen der Steuerleitung 2 und der Netzleitung 4 ist im Schema gemäß FIG 1 durch ein Ersatzschaltbild in Form eines Kondensators angedeutet.

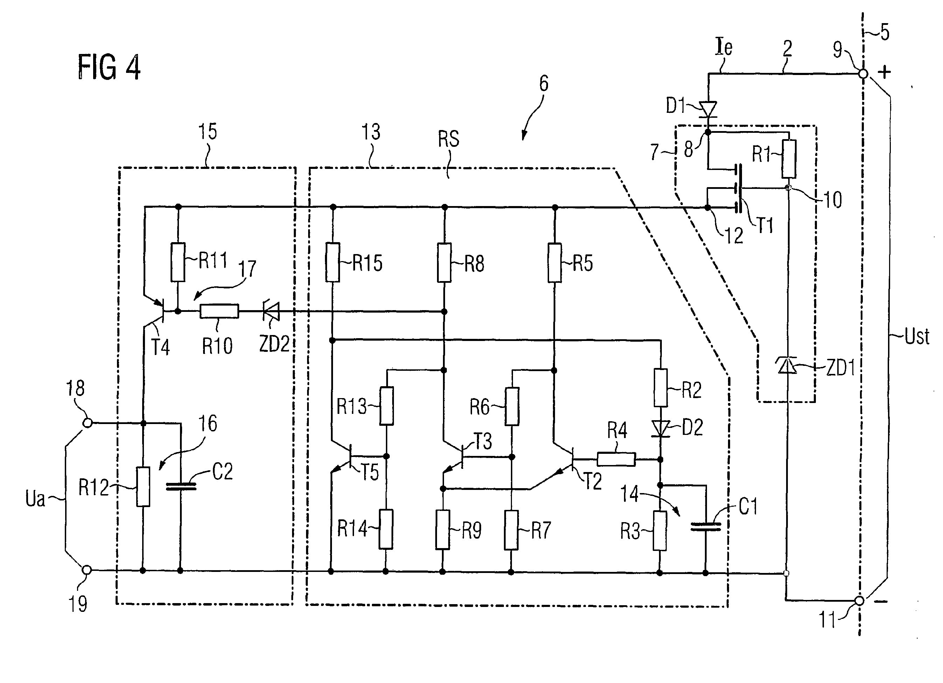

Die Steuereingangsschaltung 6 umfasst eine in die Steuerleitung 2 geschaltete Konstantstromsenke 7 (FIG 4). Die Konstantstromsenke 7 hält den Betrag des Eingangsstroms Ie auf einem konstanten, d.h. im Wesentlichen von der Steuerspannung Ust unabhängigen Betrag, sofern dieser als Stromaufnahme Ia bezeichnete Betrag zur Verfügung gestellt wird. Die Konstantstromsenke 7 wird gepulst betrieben. Mit anderen Worten ist die Stromaufnahme Ia eine Funktion der Zeit, deren Größe pulsartig variiert.

Konkret weist die Konstantstromsenke 7 während periodisch wiederkehrender Detektionspulse P (FIG 2 und 3) eine vergleichsweise hohe Stromaufnahme Ia auf. Während eines Detektionspulses P, der eine Dauer t1 von beispielsweise 4ms aufweist, nimmt die Stromaufnahme Ia einen vergleichsweise großen Wert von ca. 8mA an, der nachfolgend als Detektionswert I1 bezeichnet ist. Die Zeitspanne zwischen zwei aufeinander folgenden Detektionspulsen P ist als Ruhephase R bezeichnet. Während dieser Ruhephase R ist die Stromaufnahme Ia der Konstantstromsenke 7 gegenüber dem Detektionswert I1 deutlich, beispielsweise um einen Faktor 20, auf einen Ruhewert I2 erniedrigt. Die Dauer t2 der Ruhephase R übersteigt die Dauer t1 des Detektionspulses P um mindestens das zweifache, bevorzugt sogar das vierfache.

Liegt ein Steuersignal S vor, so fließt nahezu während der gesamten Dauer des Detektionspulses P ein konstanter Eingangsstrom Ie = I1. Während der anschließenden Ruhephase R ist der Stromfluss durch die Steuereingangsschaltung 6 auf maximal den Ruhewert I2 beschränkt, so dass während der Ruhephase R in der Steuereingangsschaltung 6 nur eine geringe Verlustleistung auftritt. Die im Zeitmittel auftretende Verlustleistung ist hierdurch vergleichsweise gering, wodurch die Gefahr einer Überhitzung des Geräts 1, insbesondere im Bereich der Steuereingangsschaltung 6 wirkungsvoll reduziert ist.

Dies ist in den Figuren 2 und 3 näher erläutert. Beide Figuren zeigen in einem zeitlichen Diagramm einen Verlauf der Steuerspannung Ust während eines Steuersignals S in Gegenüberstellung mit dem korrespondierenden Eingangsstrom Ie.

FIG 2 zeigt den Eingangsstrom Ie, der sich bei Verwendung einer sinusförmigen Wechselspannung als Steuerspannung Ust einstellt. Die Konstantstromsenke 7 synchronisiert sich, wie nachfolgend näher beschrieben wird, selbsttätig mit der Phase der Steuerspannung Ust, indem ein Detektionspuls P stets mit dem Beginn der positiven Halbwelle der Steuerspannung Ust gestartet wird. Mit anderen Worten werden die Detektionspulse P jeweils durch den Nulldurchgang der Steuerspannung Ust zur positiven Halbwelle "getriggert". Wie FIG 2 zu entnehmen ist, wird die Stromaufnahme Ia der Konstantstromsenke 7 nach dem Detektionspuls P vom Detektionswert 11 auf den vergleichsweise geringen Ruhewert I2 heruntergeschaltet, wobei sich die anschließende Ruhephase R zeitlich zumindest über die gesamte Restdauer der positiven Halbwelle der Steuerspannung Ust erstreckt. Der Betrag des Eingangsstroms Ie entspricht während der gesamten positiven Halbwelle der Steuerspannung Ust der Stromaufnahme Ia.

Die Steuerspannung Ust wird innerhalb der Steuereingangsschaltung 6 gleichgerichtet, so dass der Stromfluss in der Steuerleitung 2 während der negativen Halbwelle der Steuerspannung Ust zum Erliegen kommt.

FIG 3 zeigt den Eingangsstrom Ie, wie er sich bei zeitlich konstanter Steuerspannung Ust einstellt. In diesem Fall ist die Periode der wiederkehrenden Detektionspulse P intern durch die Steuereingangsschaltung 6 vorgegeben. Eine Periode umfasst einen Detektionspuls P der Dauer t1, an den eine Ruhephase R der Dauer t2 anschließt.

Solange kein Steuersignal S am Steuereingang 5 anliegt, ist der Eingangsstrom Ie notwendigerweise gleich der Summe aus Reststrom Ir und Störstrom Is. Diese Summe Ir + Is ist im Allgemeinen klein gegen den Detektionswert I1 und fluktuiert unregelmäßig. Während eines Detektionspulses P unterschreitet der Eingangsstrom Ie daher im Allgemeinen die von der Konstantstromsenke 7 vorgegebene Stromaufnahme Ia = I1. Dieser Wert wird allenfalls kurzzeitig erreicht, z.B. wenn infolge eines Schaltvorgangs in der mit der Steuerleitung 2 koppelnden Netzleitung 4 kurzzeitig eine hohe Störspannung eingekoppelt wird. Der Eingangsstrom Ie kann dann maximal den Detektionswert I1 erreichen. Die Dauer solcher Störeinflüsse ist jedoch in der Regel kurz gegen die Dauer t1 eines Detektionspulses P, so dass der im Zeitmittel während des Detektionspulses P fließende Eingangsstrom Ie weiterhin klein ist im Vergleich zu dem entsprechend gemittelten Eingangsstrom Ie, der während eines Steuersignals S fließt.

Durch Auswertung des während eines Detektionspulses P fließenden Eingangsstroms Ie kann also ein Steuersignal S quasi eindeutig von Störeinflüssen unterschieden werden. In der nachfolgend im Detail beschriebenen Steuereingangsschaltung 6 ist dieses Prinzip zur Erkennung eines Steuersignals S implementiert.

Ein Ausführungsbeispiel der Steuereingangsschaltung 6 ist in FIG 4 in einem elektronischen Schaltplan dargestellt. Der in die Steuerleitung 2 geschalteten Konstantstromsenke 7 ist danach eine Diode D1 zur Gleichrichtung der Steuerspannung Ust vorgeschaltet.

Die Konstantstromsenke 7 umfasst einen Feldeffekttransistor T1, dessen Drain-Anschluss 8 mit einem Eingangskontakt 9 des Steuereingangs 5 verbunden ist. Der Drain-Anschluss 8 ist über einen Widerstand R1 mit dem Gate-Anschluss 10 des Feldeffekttransistors T1 verbunden, der wiederum über eine in Sperrrichtung orientierte Zenerdiode ZD1 mit einem Ausgangskontakt 11 des Steuereingangs 5 verbunden ist. In dieser Beschaltung ist der Gate-Anschluss 10 des Feldeffekttransistors T1 mit einer konstanten Spannung belegt, die den zwischen dem Drain-Anschluss 8 und dem Source-Anschluss 12 durch den Feldeffekttransistor T1 fließenden Eingangsstrom Ie auf einen konstanten Wert, d.h. die Stromaufnahme Ia, festlegt.

Die Größe der Stromaufnahme Ia berechnet sich aus der Durchbruchspannung der Zenerdiode ZD1 dividiert durch den Gesamtwiderstand RS zwischen dem Source-Anschluss 12 des Feldeffekttransistors T1 und dem Ausgangskontakt 11. Zur Beeinflussung dieses Gesamtwiderstands RS ist dem Feldeffekttransistor T1 source-seitig ein Ansteuermodul 13 nachgeschaltet.

Das Ansteuermodul 13 umfasst drei Transistoren T2,T3 und T5, die mit Widerständen R2,R3,R4,R5,R6,R7,R8,R9,R13,R14 und R15, einer Diode D2 und einem Kondensator C1 entsprechend FIG 4 beschaltet sind.

Die Transistoren T2,T3 und T5 sind derart beschaltet, dass während des Detektionspulses P nur der Transistor T3 aufgesteuert, d.h. bezüglich der Kollektor-Emitter-Strecke leitend, ist. Der Gesamtwiderstand RS ist hierbei im Wesentlichen durch die Reihenschaltung der Widerstände R8 und R9 gegeben. Der Detektionswert I1 der Stromaufnahme Ia ergibt sich somit im Wesentlichen aus der Durchbruchspannung der Zenerdiode DC1 dividiert durch R8 + R9.

In der Ruhephase R sind dagegen die Transistoren T2 und T5 aufgesteuert. Der Gesamtwiderstand RS ergibt sich dann ungefähr aus der Parallelschaltung der Widerstände R15 und R5. Der Ruhewert I2 der Stromaufnahme Ia ist somit etwa durch die Durchbruchspannung der Zenerdiode DZ1 dividiert durch R15*R5/(R15+R5) gegeben. Durch geeignete Schaltungsdimensionierung wird erreicht, dass der Ruhewert I2 der Stromaufnahme Ia wesentlich kleiner ist als der Detektionswert I1. Die Dauer t1 des Detektionspulses P und die Dauer t2 der Ruhephase R sind unabhängig voneinander durch Dimensionierung des Kondensators C1 und der Widerstände R2 und R3 einstellbar.

Bei Verwendung einer Wechselspannung als Steuerspannung Ust läuft das Ansteuermodul 13 zu Beginn jeder positiven Halbwelle neu an. Dies geschieht dadurch, dass das durch den Widerstand R3 und den Kondensator C1 gebildete RC-Glied 14 über den Widerstand R15, den Widerstand R2 und die Diode D2 geladen wird. Hierbei steigt die Basisspannung des über den Widerstand R4 mit dem RC-Glied 14 verbundenen Transistors T2 an, bis dieser nach der Dauer t1 aufsteuert. Dies beendet den Detektionspuls P. Der Transistor T3, der bei Anlaufen des Ansteuermoduls 13 geöffnet war, wird durch den aufsteuernden Transistors T2 gesperrt, der während des Detektionspulses P gesperrte Transistor T5 bei der Sperrung des Transistors T3 wiederum aufgesteuert wird. Hierdurch wird der Widerstand R15 ausgangsseitig mit dem Ausgangskontakt 11 kurzgeschlossen. Das RC-Glied 14 wird nun nicht mehr beladen, sondern entlädt sich allmählich über den Widerstand R3.

Während der negativen Halbwelle der Steuerspannung Ust bricht der Stromfluss zusammen. Dadurch entlädt sich das RC-Glied vollständig. Zu Beginn der nächsten positiven Halbwelle der Steuerspannung Ust wiederholt sich der voranstehend beschriebene Vorgang erneut.

Bei einer konstanten Steuerspannung Ust schwingt das Ansteuermodul 13 periodisch mit dem vorgegebenen Puls-Pausen-Verhältnis zwischen dem Detektionspuls P und der Ruhephase R.

Dem Ansteuermodul 13 ist ein Auswertemodul 15 parallelgeschaltet. Das Auswertemodul 15 umfasst ein zwischen den Source-Ausgang 12 des Feldeffekttransistors T1 und dem Ausgangskontakt 11 geschaltetes RC-Glied 16, das aus einem Widerstand R12 und einem Kondensator C2 gebildet ist. Zwischen den Feldeffekttransistor T1 und das RC-Glied 16 ist eine Schwellenschaltung 17 geschaltet, die die Verbindung zwischen dem RC-Glied 16 und dem Feldeffekttransistor T1 öffnet, wenn der Eingangsstrom Ie einen vorgegebenen Einschaltwert überschreitet. Die Schwellenschaltung 17 greift hierzu mittels einer Spannungsteilerschaltung mit den Widerständen R10 und R11 sowie einer in Sperrrichtung orientierten Zenerdiode ZD2 die Spannung über dem während des Detektionspulses P stromdurchflossenen Widerstand R8 ab. Die Schwellenschaltung 17 umfasst weiterhin einen Transistor T4, der basisseitig auf das Ausgangspotential des Widerstands R11 gelegt ist. Der Transistor T4 wird aufgesteuert, wenn über dem Widerstand R8 die Durchbruchspannung der Zenerdiode ZD2 anliegt, und infolgedessen Strom durch die Widerstände R10,R11 und die Zenerdiode ZD2 fließt. Die über dem Widerstand R8 anliegende Spannung ist proportional zu dem durch den Widerstand R8 fließenden Eingangsstrom Ie. Die Durchbruchspannung der Zenerdiode ZD2 ist dabei so gewählt, dass Transistor T4 aufgesteuert wird, wenn der Eingangsstrom Ie dem Einschaltwert von etwa 85 % des Detektionswerts I1 entspricht.

Bei aufgesteuertem Transistor T4 wird das RC-Glied 16 beladen. Hierdurch steigt die über dem RC-Glied 16 anliegende Spannung, die an Kontakten 18 und 19 als Ausgangsspannung Ua abgegriffen werden kann, während des Detektionspulses P allmählich an.

Während der Ruhephase R entspricht der Eingangsstrom Ie maximal dem Ruhewert I2 der Stromaufnahme Ia. Dieser Ruhewert I2 unterschreitet deutlich den Einschaltwert, so eine weitere Beladung des RC-Glieds 16 ausgeschlossen ist. Das RC-Glied 16 wird infolgedessen während der Ruhephase R über den Widerstand R12 entladen.

Bei vorliegendem Steuersignal S ist der Transistor T4 während eines Detektionspulses P größtenteils aufgesteuert. Die Ausgangsspannung Ua erreicht dadurch am Ende des Detektionspulses P einen vergleichsweise hohen Wert, der dann eine vorgegebene Auslöseschwelle erreicht, wenn der Eingangsstrom Ie während einer vorgegebenen Einschaltdauer den Einschaltwert nicht unterschreitet. Die Einschaltdauer ist geringfügig kürzer gewählt als die Dauer t1 des Detektionspulses P, um Flankenanstiegszeiten des Eingangsstroms und dergleichen abzufedern. Vorzugsweise beträgt die Einschaltdauer etwa 90% der Dauer t1.

Daran, dass die Ausgangsspannung Ua die Auslöseschwelle erreicht oder überschreitet, wird wiederum in nicht näher dargestellter Weise von einer an die Kontakte 18 und 19 angeschlossenen internen Gerätesteuerung des Geräts 1 das Vorliegen des Steuersignals S erkannt und eine dem Steuersignal S entsprechende Reaktion des Geräts 1 ausgelöst.

Liegt kein Steuersignal S vor, so bleibt der Transistor T4 während des Detektionspulses P größtenteils gesperrt. Die Aufladung des RC-Glieds 16 unterbleibt damit weitgehend. Die Ausgangsspannung Ua verbleibt hierdurch auf einem sehr geringen Wert, der insbesondere die Auslöseschwelle ständig unterschreitet.

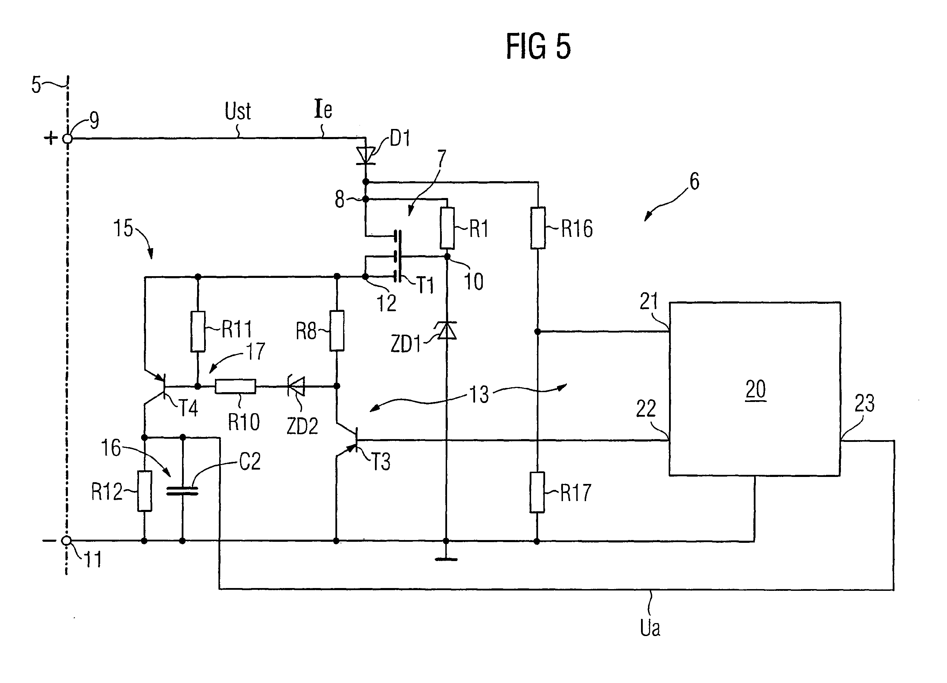

In einem alternativen Ausführungsbeispiel der Steuereingangsschaltung 6 gemäß FIG 5 ist eine Teilfunktion des Ansteuermoduls 13 in einem Mikroprozessor 20 implementiert. Dem Mikroprozessor 20 ist ein Bruchteil der gleichgerichteten Steuerspannung Ust über einen aus Widerständen R16 und R17 bestehenden Spannungsteiler über einen Spannungseingang 21 zugeführt. Der Mikroprozessor 20 verfügt weiterhin über einen Steuerausgang 22, über welchen er in Abhängigkeit von der Steuerspannung Ust den Transistor T3 ansteuert. Der Transistor T3 ist analog zum Ausführungsbeispiel gemäß FIG 4 in Reihe mit dem Widerstand R8 zwischen dem Source-Anschluss 12 des Feldeffekttransistors T1 und den Ausgangskontakt 11 des Steuereingangs 5 geschaltet. Der Transistor T3 wird vom Mikroprozessor 20 derart angesteuert, dass ein zeitlicher Verlauf des Eingangsstroms Ie entsprechend den FIG 2 und 3 erfolgt.

Der Eingangsstrom Ie wird von dem Auswertemodul 15 analysiert, dessen Ausführung und Funktionsweise gegenüber FIG 4 unverändert ist. Die Ausgangsspannung Ua ist jedoch einem Auslöseeingang 23 des Mikroprozessors 20 zugeführt. Der Mikroprozessor 20 übernimmt hierbei gleichzeitig die Funktion einer internen Gerätesteuerung und steuert in dieser Funktion das Gerät 1 entsprechend an, wenn die Ausgangsspannung Ua die vorgegebene Auslöseschwelle übersteigt.

Die Verwendung des Begriffs "Modul" für die funktionalen Gruppen der Steuereingangsschaltung 6, insbesondere Ansteuermodul 13 und Auswertemodul 15, impliziert nicht notwendigerweise eine räumliche Trennung dieser Gruppen. Vielmehr sind die gesamte Steuereingangsschaltung 6 oder beliebige Teile davon bevorzugt in beliebiger räumlicher Anordnung auf einem gemeinsamen Schaltungsträger angeordnet. Die Steuereingangsschaltung 6 oder Teile davon sind vorzugsweise als integrierter Schaltkreis (ASIC) realisiert.

## Patentansprüche

1. Steuereingangsschaltung (6) für ein elektrisches Gerät (1), mit einem Auswertemodul (15), das dazu ausgebildet ist, ein in einer Steuerleitung (2) übermitteltes elektronisches Steuersignal (S) zu detektieren,
**gekennzeichnet durch** eine in die Steuerleitung (2) geschaltete Konstantstromsenke (7), die innerhalb eines vorgegebenen Spannungsintervalls einer an der Steuerleitung (2) anliegenden Steuerspannung (Ust) eine von dem Wert der Steuerspannung (Ust) im Wesentlichen unabhängige Stromaufnahme (Ia) aufweist, wobei die Konstantstromsenke (7) derart beschaltet ist, dass die Stromaufnahme (Ia) periodisch für jeweils eine Zeitspanne (t1) einen Detektionswert (I1) annimmt, demgegenüber die Stromaufnahme (Ia) außerhalb dieser Zeitspanne (t1) erniedrigt ist, und wobei das Auswertemodul (15) dazu ausgebildet ist, das Vorliegen des Steuersignals (S) zu detektieren, wenn während der besagten Zeitspanne (t1) ein in der Steuerleitung (2) fließender Eingangsstrom (Ie) für eine vorgegebene Einschaltdauer einen vorgegebenen Einschaltwert nicht unterschreitet.

2. Steuereingangsschaltung (6) nach Anspruch 1, **dadurch gekennzeichnet, dass** die Konstantstromsenke (7) mit einem Ansteuermodul (13) beschaltet ist, das die Größe der Stromaufnahme (Ia) vorgibt.

3. Steuereingangsschaltung (6) nach Anspruch 1 oder 2, **dadurch gekennzeichnet, dass** das Ansteuermodul (13) eine Oszillatorschaltung ist, deren Gesamtwiderstand (RS) diskret zwischen zwei Werten wechselt.

4. Steuereingangsschaltung (6) nach Anspruch 1 oder 2, **dadurch gekennzeichnet, dass** das Ansteuermodul (13) einen Mikroprozessor (20) umfasst.

5. Steuereingangsschaltung (6) nach einem der Ansprüche 1 bis 4, **dadurch gekennzeichnet, dass** der Konstantstromsenke (7) eine Diode (D1) vorgeschaltet ist.

6. Steuereingangsschaltung (6) nach einem der Ansprüche 1 bis 5, **dadurch gekennzeichnet, dass** das Auswertemodul (15) ein RC-Glied (16) umfasst.

7. Steuereingangsschaltung (6) nach Anspruch 6, **dadurch gekennzeichnet, dass** dem RC-Glied (16) eine Schwellenschaltung (17) vorgeschaltet ist, die nur dann einen Stromfluss auf das RC-Glied (16) zulässt, wenn Eingangsstrom (Ie) den Einschaltwert überschreitet.

8. Steuereingangsschaltung (6) nach einem der Ansprüche 1 bis 7, **dadurch gekennzeichnet, dass** die Konstantstromsenke (7) einen Feldeffekttransistor (T1) umfasst.

9. Steuereingangsschaltung (6) nach einem der Ansprüche 1 bis 8, **dadurch gekennzeichnet, dass** die Detektionspulse (P) zeitlich periodisch aufeinanderfolgen.

10. Steuereingangsschaltung (6) nach Anspruch 9, **dadurch gekennzeichnet, dass** bei einem Steuersignal (S) in Form einer zeitlich wechselnden Steuerspannung (Ust) die Periode der Detektionspulse (P) mit der Phase der Steuerspannung (Ust) koordiniert ist.

11. Steuereingangsschaltung (6) nach Anspruch 10, **dadurch gekennzeichnet, dass** jeweils ein Detektionspuls (P) koordiniert mit jeder positiven Halbwelle der Steuerspannung (Ust) beginnt.

12. Steuereingangsschaltung (6) nach einem der Ansprüche 1 bis 11, **dadurch gekennzeichnet, dass** die Stromaufnahme (Ia) der Konstantstromsenke (7) zwischen zwei aufeinanderfolgenden Detektionspulsen (P) gegenüber dem Detektionswert (I1) um mindestens einen Faktor 10 erniedrigt ist.

13. Steuereingangsschaltung (6) nach einem der Ansprüche 1 bis 12, **dadurch gekennzeichnet, dass** der Einschaltwert des Eingangsstroms (Ie) etwa 85% des Detektionswertes (I1) entspricht.

14. Steuereingangsschaltung (6) nach einem der Ansprüche 1 bis 13, **dadurch gekennzeichnet, dass** die Einschaltdauer mindestens 70% der Dauer (t1) des Detektionspulses (P) beträgt.

15. Steuereingangsschaltung (6) nach einem der Ansprüche 1 bis 14, **dadurch gekennzeichnet, dass** die Dauer (t2) der Zeitspanne zwischen zwei aufeinanderfolgenden Detektionspulsen (P) die Dauer (t1) des oder jeden Detektionspulses (P) um mindestens das zweifache übersteigt.

16. Steuereingangsschaltung (6) nach einem der Ansprüche 1 bis 15, **dadurch gekennzeichnet, dass** der Detektionswert (I1) etwa 8mA beträgt.

17. Steuereingangsschaltung (6) nach einem der Ansprüche 1 bis 16, **dadurch gekennzeichnet, dass** die Dauer (t1) eines Detektionspulses (P) etwa 4ms beträgt.

18. Steuereingangsschaltung (6) nach einem der Ansprüche 1 bis 17, **dadurch gekennzeichnet, dass** das Ansteuermodul (13) und/oder das Auswertemodul (15) als integrierter Schaltkreis realisiert sind.

19. Elektrisches Gerät (1) mit einer Steuereingangsschaltung (6) nach einem der Ansprüche 1 bis 17.

## Claims

1. Control input circuit (6) for an electrical appliance (1), having an evaluation module (15) which is designed to detect an electronic control signal transmitted in a control line (2), **characterized by** a constant current sink (7) which is connected into the control line (2) and whose drawn current (Ia) within a prescribed voltage interval for a control voltage (Ust) on the control line (2) is essentially independent of the value of the control voltage (Ust), where the constant current sink (7) is connected up such that the drawn current (Ia) periodically assumes a detection value (I1) for a respective time period (t1), whereas the drawn current (Ia) is lowered outside of this time period (t1), and where the evaluation module (15) is designed to detect the presence of the control signal (S) if, during said time period (t1), an input current (Ie) flowing in the control line (2) is not below a prescribed turned-on value for a prescribed turned-on period.

2. Control input circuit (6) according to Claim 1, **characterized in that** the constant current sink (7) has an actuation module (13) connected to it which prescribes the magnitude of the drawn current (Ia).

3. Control input circuit (6) according to Claim 1 or 2, **characterized in that** the actuation module (13) is an oscillator circuit whose total resistance (RS) alternates discretely between two values.

4. Control input circuit (6) according to Claim 1 or 2, **characterized in that** the actuation module (13) comprises a microprocessor (20).

5. Control input circuit (6) according to one of Claims 1 to 4, **characterized in that** the constant current sink (7) has a diode (D1) connected upstream of it.

6. Control input circuit (6) according to one of Claims 1 to 5, **characterized in that** the evaluation module (15) comprises an RC element (16).

7. Control input circuit (6) according to Claim 6, **characterized in that** the RC element (16) has a threshold circuit (17) connected upstream of it which permits a flow of current to the RC element (16) only if the input current (Ie) exceeds the turned-on value.

8. Control input circuit (6) according to one of Claims 1 to 7, **characterized in that** the constant current sink (7) comprises a field effect transistor (T1).

9. Control input circuit (6) according to one of Claims 1 to 8, **characterized in that** the detection pulses (P) are periodically successive in time.

10. Control input circuit (6) according to Claim 9, **characterized in that** when the control signal (S) is in the form of a control voltage (Ust) which alternates over time the period of the detection pulses (P) is coordinated with the phase of the control voltage (Ust).

11. Control input circuit (6) according to Claim 10, **characterized in that** a respective detection pulse (P) starts in coordination with each positive half cycle of the control voltage (Ust).

12. Control input circuit (6) according to one of Claims 1 to 11, **characterized in that** the drawn current (Ia) of the constant current sink (7) between two successive detection pulses (P) is lowered by at least a factor of 10 in comparison with the detection value (I1).

13. Control input circuit (6) according to one of Claims 1 to 12, **characterized in that** the turned-on value of the input current (Ie) corresponds to approximately 85% of the detection value (I1).

14. Control input circuit (6) according to one of Claims 1 to 13, **characterized in that** the turned-on period is at least 70% of the length (t1) of the detection pulse (P).

15. Control input circuit (6) according to one of Claims 1 to 14, **characterized in that** the length (t2) of the period of time between two successive detection pulses (P) exceeds the length (t1) of the or each detection pulse (P) by at least twofold.

16. Control input circuit (6) according to one of Claims 1 to 15, **characterized in that** the detection value (I1) is approximately 8 mA.

17. Control input circuit (6) according to one of Claims 1 to 16, **characterized in that** the length (t1) of a detection pulse (P) is approximately 4 ms.

18. Control input circuit (6) according to one of Claims 1 to 17, **characterized in that** the actuation module (13) and/or the evaluation module (15) are in the form of an integrated circuit.

19. Electrical appliance (1) having a control input circuit (6) according to one of Claims 1 to 17.

## Revendications

1. Circuit (6) d'entrée de commande d'un appareil (1) électrique, comprenant un module (15) d'exploitation constitué de manière à détecter un signal (S) électronique de commande transmis dans une ligne (2) de commande,
**caractérisé par** un puits (7) de courant constant, qui est monté dans la ligne (2) de commande et qui a, dans un intervalle de tension prescrit d'une tension (Ust) de commande s'appliquant à la ligne (2) de commande, une absorption (Ia) de courant sensiblement indépendante de la valeur de la tension (Ust) de commande, le puits (7) de courant constant étant monté de façon à ce que l'absorption (Ia) de courant prenne périodiquement, pour respectivement un laps de temps (t1), une valeur (I1) de détection, alors que l'absorption (Ia) de courant est abaissée à l'extérieur de ce laps de temps (t1), et le module (15) d'exploitation étant constitué de façon à détecter la présence du signal (S) de commande si, pendant ledit laps de temps (t1), un courant (Ie) d'entrée passant dans la ligne (2) de commande ne devient pas inférieur, pendant une durée de connexion prescrite, à une valeur de connexion prescrite.

2. Circuit (6) d'entrée de commande suivant la revendication 1, **caractérisé en ce que** le puits (7) de courant constant est monté avec un module (13) de commande qui prescrit la valeur de l'absorption (Ia) de courant.

3. Circuit (6) d'entrée de commande suivant la revendication 1 ou 2, **caractérisé en ce que** le module (13) de commande est un circuit oscillant qui alterne la résistance (RS) globale d'une manière discrète entre deux valeurs.

4. Circuit (6) d'entrée de commande suivant la revendication 1 ou 2, **caractérisé en ce que** le module (13) de commande comprend un microprocesseur (20).

5. Circuit (6) d'entrée de commande suivant l'une des revendications 1 à 4, **caractérisé en ce qu'**une diode (D1) est montée en amont du puits (7) de courant constant.

6. Circuit (6) d'entrée de commande suivant l'une des revendications 1 à 5, **caractérisé en ce que** le module (15) d'exploitation comprend un élément RC (16).

7. Circuit (6) d'entrée de commande suivant la revendication 6, **caractérisé en ce qu'**il est monté, en amont de l'élément RC (16), un circuit (17) de seuil qui n'autorise un flux de courant sur l'élément RC (16) que si le courant (Ie) d'entrée dépasse la valeur de connexion.

8. Circuit (6) d'entrée de commande suivant l'une des revendications 1 à 7, **caractérisé en ce** le puits (7) de courant constant comprend un transistor (T1) à effet de champ.

9. Circuit (6) d'entrée de commande suivant l'une des revendications 1 à 8, **caractérisé en ce que** les impulsions (P) de détection se succèdent périodiquement dans le temps.

10. Circuit (6) d'entrée de commande suivant la revendication 9, **caractérisé en ce que**, pour un signal (S) de commande sous la forme d'une tension (Ust) de commande alternant dans le temps, la période de l'impulsion (P) de détection est coordonnée avec la phase de la tension (Ust) de commande.

11. Circuit (6) d'entrée de commande suivant la revendication 10, **caractérisé en ce que** respectivement une impulsion (P) de détection commence de manière coordonnée avec chaque demi-onde positive de la tension (Ust) de commande.

12. Circuit (6) d'entrée de commande suivant l'une des revendications 1 à 11, **caractérisé en ce que** l'absorption (Ia) de courant du puits (7) de courant constant est abaissée, entre deux impulsions (P) de détection successives par rapport à la valeur (I1) de détection, d'au moins un facteur de 10.

13. Circuit (6) d'entrée de commande suivant l'une des revendications 1 à 12, **caractérisé en ce que** la valeur de connexion du courant (Ie) d'entrée représente environ 85 % de la valeur (I1) de détection.

14. Circuit (6) d'entrée de commande suivant l'une des revendications 1 à 13, **caractérisé en ce que** la durée de connexion représente au moins 70 % de la durée (t1) de l'impulsion (P) de détection.

15. Circuit (6) d'entrée de commande suivant l'une des revendications 1 à 14, **caractérisé en ce que** la durée (t2) des laps de temps entre deux impulsions (P) de détection successives dépasse la durée (t1) de l'impulsion (P) de détection de chaque impulsion (P) de détection au moins du double.

16. Circuit (6) d'entrée de commande suivant l'une des revendications 1 à 15, **caractérisé en ce que** la valeur (I1) de détection est d'environ 8 mA.

17. Circuit (6) d'entrée de commande suivant l'une des revendications 1 à 16, **caractérisé en ce que** la durée (t1) d'une impulsion (P) de détection est d'environ 4 ms.

18. Circuit (6) d'entrée de commande suivant l'une des revendications 1 à 17, **caractérisé en ce que** le module (13) de commande et/ou le module (15) d'exploitation sont réalisés sous la forme d'un circuit intégré.

19. Appareil (1) électrique ayant un circuit (6) d'entrée de commande suivant l'une des revendications 1 à 17.
